# EUROPÄISCHE PATENTSCHRIFT

(11) **EP 0 456 856 B1**
(45) Veröffentlichungstag und Bekanntmachung des Hinweises auf die Patenterteilung: **10.11.1993**
(21) Anmeldenummer: 90109254.4
(22) Anmeldetag: 16.05.1990
(51) Int. Cl.: H05K 9/00, H01R 23/68

(54) **Verfahren zur Kontaktierung von Schirmblechen**
Process for contacting magnetic screen plates
Procédé pour la mise en contact de plaques d'écrans magnétiques

(43) Veröffentlichungstag der Anmeldung: 21.11.1991
(73) Patentinhaber: SIEMENS AKTIENGESELLSCHAFT, 80333 München (DE)
(72) Erfinder: Seidel, Peter, Dipl.-Ing., D-8038 Gröbenzell (DE); Zell, Karl, Dipl.-Ing., D-8134 Niederpöcking (DE)

(56) Entgegenhaltungen:
- EP-A- 0 098 212
- DE-A- 3 537 653

## Beschreibung

Die Erfindung betrifft ein Verfahren zur Kontaktierung von auf der oberen Seite einer Leiterplatte angebrachten, mit Einpreßstiften versehenen Schirmblechen mit auf der unteren Seite angeordneten, ebenfalls Einpreßstifte aufweisenden Schirmblechen.

Ein solches Verfahren ist aus DE-A-3537 653 bekannt.

Bisher waren die Anforderungen an eine hochfrequenzmäßige Abschirmung von auf Leiterplatten befindlichen Steckern bzw. Baugruppen im allgemeinen noch nicht sehr hoch. So reicht es in den meisten Fällen aus, in einem verhältnismäßig großen Abstand die Schirmungsbleche auf der Baugruppenleiterplatte zu kontaktieren. Dabei mußten auch Aussparungen in den Schirmblechen durch die gegenseitig abwechselnde Einpressung in Kauf genommen werden. Derartige Kontaktierungen der Schirmbleche sind bei Datenübertragungen mit Datenübertragungsraten von mehreren 100 MBit/s nicht mehr ausreichend.

Aufgabe der vorliegenden Erfindung ist es, ein Verfahren der eingangs genannten Art anzugeben, welches auf einfache Art und Weise eine Schirmung von auf Baugruppenleiterplatten angeordneten Steckern bzw. Baugruppen ermöglicht, die auch im Falle hoher Datenübertragungsraten eine störungsfreie Übertragung ermöglicht.

Diese Aufgabe wird erfindungsgemäß für ein Verfahren der obengenannten Art dadurch gelöst, daß die Einpreßstifte der oberen Schirmbleche kreisbogenförmige Einpreßzonen aufweisen, während die Einpreßstifte der unteren Schirmbleche V-förmige Einpreßzonen aufweisen, wobei die Scheitelpunkte der beiden gebogenen Einpreßzonen immer auf derselben Seite liegen, daß zuerst das obere Schirmblech mit seinen Einpreßstiften kraftlos in die durchzukontaktierenden Leiterplattenlöcher eingelegt wird, und daß anschließend durch Einpressen des unteren Schirmblechs mit seinen V-förmigen Einpreßstiften in die bereits belegten Leiterplattenlöcher eine feste Kontaktierung zwischen den jeweiligen Einpreßstiften und der Leiterplatte hergestellt wird.

Durch die Verringerung des notwendigen Teilungsabstandes sowie durch den Wegfall der Aussparungen für das gegenseitige Einpressen wird bei dem erfindungsgemäßen Verfahren durch das Einpressen der einzelnen Einpreßbereiche des oberen und unteren Schirmblechs in nur einem durchkontaktierten Loch der Leiterplatte eine optimale Schirmung erreicht. Bei dem erfindungsgemäßen Verfahren wird eine gasdichte, allzeit gute Kontaktierung, d. h. Schirmableitung, erreicht.

Im folgenden wird die Erfindung anhand eines in der Zeichnung dargestellten Ausführungsbeispiels näher erläutert.

Es zeigen
- FIG 1: die Kontaktierung eines oberen und eines unteren Schirmbleches mit der Leiterplatte in der bekannten Art,
- FIG 2: die Kontaktierung eines oberen und eines unteren Schirmbleches sowohl miteinander als auch mit der Leiterplatte gemäß der vorliegenden Erfindung,
- FIG 3: einen Querschnitt durch ein durchkontaktiertes Leiterplattenloch gemäß dem Verfahren der vorliegenden Erfindung, und
- FIG 4: ein Anwendungsbeispiel für das Verfahren der vorliegenden Erfindung.

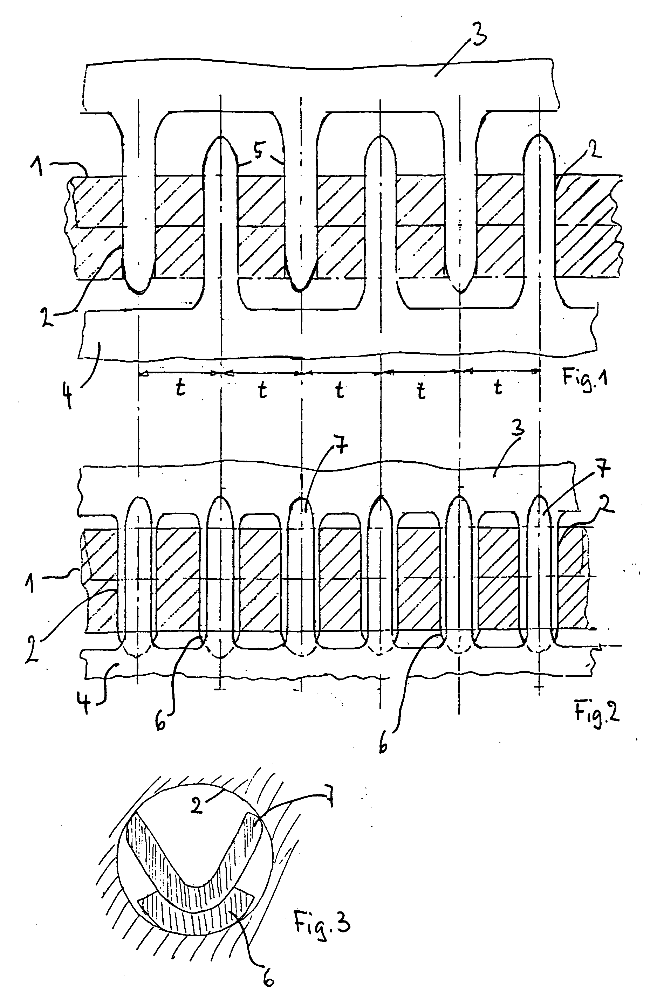

FIG 1 zeigt die bisherige Kontaktierung von oberen und unteren Schirmblechen mit der Baugruppenleiterplatte 1. Die Einpreßstifte 5 der oberen Leiterplatte 3 sowie der unteren Leiterplatte 4 wurden abwechselnd in Leiterplattenlöcher 2 der Leiterplatte eingepreßt. Auch mußten Aussparungen in den Schirmblechen aufgrund dieser gegenseitig abwechselnden Einpressung in Kauf genommen werden, wie aus FIG 1 zu ersehen ist.

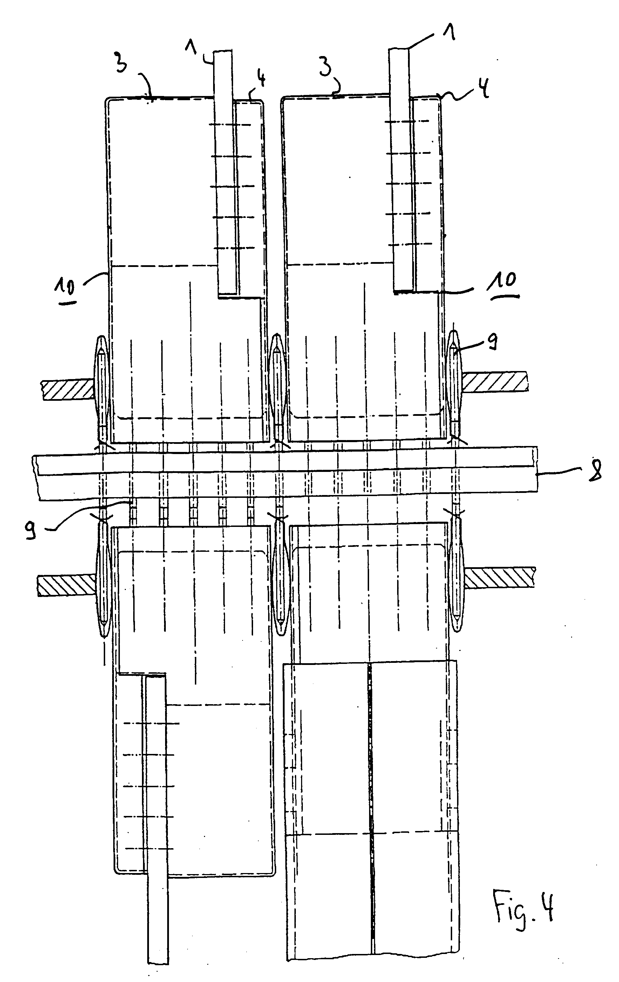

FIG 2 zeigt eine Kontaktierung des oberen Schirmblechs mit einem unteren Schirmblech gemäß der vorliegenden Erfindung bei gleichem Teilungsabstand t. Die Verbesserung der Schirmung ist schon rein optisch beim Vergleich der beiden Figuren zu erkennen.

Bei dem erfindungsgemäßen Verfahren werden die Einpreßstifte sowohl des oberen Schirmblechs 3 als auch die Einpreßstifte des unteren Schirmbleches 4 jeweils in ein und dasselbe Leiterplattenloch 2 eingeführt. Aus der FIG 2 ergibt sich eindeutig, daß der zwangsläufig konstruktionsmäßig nicht abgeschirmte Raum gegenüber dem bisherigen Verfahren wesentlich verkleinert worden ist.

Um eine gute Kontaktierung zu erreichen, haben die Einpreßstifte der einen Schirmbleche, z. B. der oberen Schirmbleche, kreisbogenförmige Einpreßzonen, während die Einpreßstifte der anderen Schirmbleche, in diesem Falle der unteren Schirmbleche, V-förmige Einpreßzonen aufweisen. Die Schirmbleche mit den kreisbogenförmigen Einpreßzonen werden zuerst kraftlos mit ihren Einpreßstiften 6 in die Leiterplattenlöcher 2 eingelegt. Anschließend wird das untere Schirmblech 4 mit seinen V-förmigen Einpreßstiften 7 von der anderen Seite mit Kraftaufwand in die Leiterplattenlöcher 2 eingepreßt. Die dann erreichte Kontaktierung ergibt sich aus dem in FIG 3 dargestellten Schnittbild.

In FIG 4 ist ein Anwendungsbeispiel des erfindungsgemäßen Verfahrens dargestellt. Es sind nur die zum Verständnis der Anwendung des erfindungsgemäßen Verfahrens notwendigen Bauteile gekennzeichnet. Bei dem in FIG 4 dargestellten Beispiel handelt es sich um eine Rückwandverdrahtung 8 mit senkrecht auf ihr stehenden Kontaktmessern 9. Auf diese Kontaktmesser sind mehrere Stecker 10, die auf einer Baugruppenleiterplatte 1 montiert sind, aufgesteckt. Diese Stecker 10 sind jeweils durch obere Schirmbleche 3 und untere Schirmbleche 4 abgeschirmt. Bei dem vorliegenden erfindungsgemäßen Verfahren geht es um die Kontaktierung der unteren und oberen Schirmbleche mit der Leiterplatte 1.

## Patentansprüche

1. Verfahren zur Kontaktierung von auf der oberen Seite einer Leiterplatte angebrachten, mit Einpreßstiften versehenen Schirmbleche mit auf der unteren Seite angeordneten, ebenfalls Einpreßstifte aufweisenden Schirmblechen,
**dadurch gekennzeichnet,**
daß die Einpreßstifte (6) der oberen Schirmbleche (3) kreisbogenförmige Einpreßzonen aufweisen, während die Einpreßstifte (7) der unteren Schirmbleche (4) V-förmige Einpreßzonen aufweisen, wobei die Scheitelpunkte der beiden gebogenen Einpreßzonen immer auf derselben Seite liegen, daß zuerst das obere Schirmblech (3) mit seinen Einpreßstiften (6) kraftlos in die durchzukontaktierenden Leiterplattenlöcher (2) eingelegt wird, und daß anschließend durch Einpressen des unteren Schirmblechs (4) mit seinen V-förmigen Einpreßstiften (7) in die bereits belegten Leiterplattenlöcher (2) eine feste Kontaktierung zwischen den jeweiligen Einpreßstiften (6, 7) und der Leiterplatte hergestellt wird.

## Claims

1. Method of making contact between screening plates mounted on the upper side of a printed circuit board and provided with press-fit pins and screening plates disposed on the lower side and also having press-fit pins, characterised in that the press-fit pins (6) of the upper screening plates (3) have press-fit zones of circular-arc shape, while the press-fit pins (7) of the lower screening plates (4) have V-shaped press-fit zones, the apices of the two curved press-fit zones always being on the same side, in that the press-fit pins (6) of the upper screening plate (3) are first inserted without force into the printed circuit board holes (2) through which contact is to be made, and in that a firm contact is then made between the respective press-fit pins (6, 7) and the printed circuit board by pressing the V-shaped press-fit pins (7) of the lower screening plate (4) into the already occupied printed circuit board holes (2).

## Revendications

1. Procédé de mise en contact de tôles de blindage, qui sont montées sur la face supérieure d'une plaquette à circuits imprimés et qui sont munies de tiges enfichables, avec des tôles de blindage disposées sur la face inférieure et comportant également des tiges enfichables,
caractérisé par le fait
que les tiges enfichables (6) des tôles de blindage supérieures (3) comportent des zones d'enfichage en forme d'arc de cercle, tandis que les tiges enfichables (7) des tôles de blindage inférieures (4) comportent des zones d'enfichage en forme de V, les sommets des deux zones enfichables repliées étant situés toujours du même côté, qu'on insère tout d'abord la tôle de blindage supérieure (3) munie des tiges enfichables (6), sans appliquer de force, dans les trous (2) de la plaquette à circuits imprimés, dans lesquels doit être établi un contact traversant, et qu'ensuite, en enfonçant les tiges enfichables (7) en forme de V de la tôle de blindage inférieure (4) dans les trous déjà occupés (2) de la plaquette à circuits imprimés, on établit un contact fixe entre les tiges enfichables respectives (6,7) et la plaquette à circuits imprimés.
